# DEMANDE DE BREVET EUROPEEN

(11) **EP 2 738 796 A2**
(43) Date de publication de la demande: **04.06.2014**
(21) Numéro de dépôt: 13194581.8
(22) Date de dépôt: 27.11.2013
(51) Int. Cl.: H01L 21/60, H01L 23/485

(54) **Procédé de réalisation d'une structure pour l'assemblage de dispositifs microélectroniques en puce retournée comprenant un bloc isolant de guidage d'un élément de connexion et dispositif correspondant**

(30) Priorité: 29.11.2012 FR 1261391
(71) Demandeur: Commissariat à l'Énergie Atomique et aux Énergies Alternatives, 75015 Paris (FR)
(72) Inventeur: Pares, Gabriel, 38190 Bernin (FR)
(74) Mandataire: Ilgart, Jean-Christophe

(57) **Abrégé**

L'invention concerne la réalisation d'un dispositif microélectronique (C) et le dispositif (C) correspondant, le dispositif microélectronique (C) comprenant un substrat (100) comportant au moins un plot conducteur (108a, 108b), ledit plot (108a, 108b) étant doté d'une face inférieure reposant sur le substrat (100) et d'une face supérieure opposée à ladite face inférieure, ladite face supérieure dudit plot (108a, 108b) étant recouverte d'un empilement formé d'une couche conductrice (110) et d'une couche de protection diélectrique (111) comportant une ouverture (115) dite première ouverture en regard dudit plot (108a, 108b) et dévoilant ladite couche conductrice (110), au moins un bloc isolant (120a, 120b) étant agencé sur une zone périphérique de ladite face supérieure dudit plot (108a, 108b), ledit bloc isolant (120a, 120b) ayant une section transversale formant un contour fermé et comportant une ouverture (125) dite deuxième ouverture, un pilier conducteur (130a, 130b, 330a) étant situé au centre dudit contour dans ladite deuxième ouverture (125), la hauteur du pilier conducteur (130a, 130b, 330a) et la hauteur du bloc isolant (120a, 120b) étant prévues l'une par rapport à l'autre de sorte qu'un espace vide (135) ou une cavité (135) est conservé(e) entre le sommet (131) dudit pilier conducteur (130a, 130b, 330a) et une zone d'embouchure de ladite deuxième ouverture (125) située au niveau du sommet (121) dudit bloc isolant (120a, 120b). Le bloc isolant (120a, 120b) forme en outre un moyen de guidage mécanique d'un élément de connexion (230a, 230b) d'un autre dispositif microélectronique (C') que l'on peut venir assembler au dispositif microélectronique (C) comportant le pilier conducteur (130a, 130b, 330a), ledit espace vide (135) étant prévu de sorte à permettre une insertion dans ladite ouverture (125) dudit élément de connexion (230a, 230b) du deuxième dispositif microélectronique (C').

## Description

### DOMAINE TECHNIQUE

L'invention concerne le domaine de la microélectronique et celui de l'assemblage et de l'interconnexion de dispositifs microélectroniques tels que des cartes, des substrats, des supports de puces, des puces, des composants.

Elle prévoit un procédé de réalisation d'une structure pour l'assemblage de dispositifs microélectroniques, permettant de faciliter le positionnement desdits dispositifs l'un par rapport à l'autre tout en réalisant une bonne isolation des éléments conducteurs permettant d'interconnecter ces dispositifs ainsi qu'une bonne tenue mécanique.

### ART ANTERIEUR

On cherche de plus en plus à réaliser des empilements verticaux de puces ou de composants.

Pour connecter entre elles la face inférieure et la face supérieure d'une puce, il est bien connu de réaliser des connexions appelées via TSV (« TSV » pour « through silicon via ») traversant l'épaisseur d'un substrat à partir duquel la puce est formée.

Pour connecter et assembler des puces entre elles, des éléments de connexion sous forme de micro-piliers ou encore de micro-bosses peuvent être mis en oeuvre. L'assemblage se fait alors en reportant des micro-piliers ou des micro-bosses par exemple d'une puce ou composant sur des micro-piliers ou des micro-bosses d'une autre puce ou composant, un matériau de soudure assurant la liaison entre les puces.

Avec les deux types de connexions électriques précitées, différentes configurations de report peuvent être réalisées.

Selon une première configuration, communément appelée « F2F » ou « flip chip », les puces sont assemblées de telle sorte que leurs faces actives sont mises en regard l'une de l'autre.

Selon une deuxième configuration communément appelée « B2F » ou « F2B », l'assemblage est mis en oeuvre de sorte que leurs deux faces actives sont orientées dans la même direction.

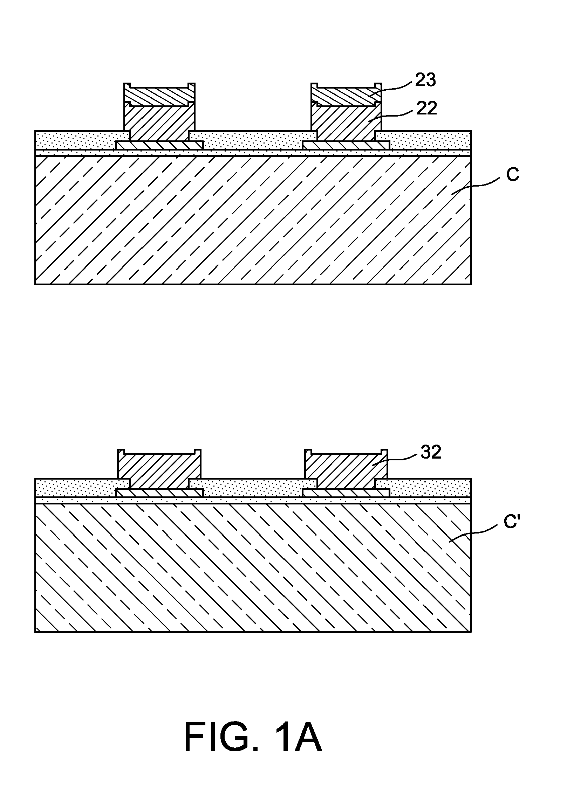

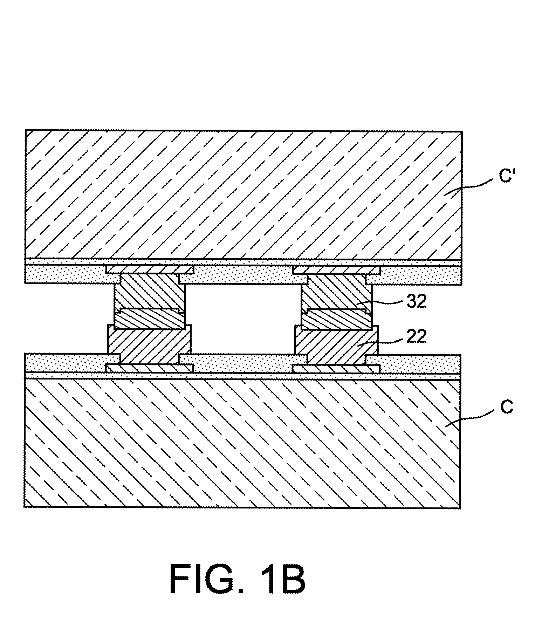

Les figures 1A-1C illustrent un assemblage de puces réalisé suivant l'art antérieur, dans lequel on forme un matériau 23 de soudure sur des plots ou des piliers conducteurs 22 disposés sur une surface active d'une puce ou composant C, que l'on assemble avec des piliers conducteurs 32 d'une autre puce ou composant C' (figures 1A et 1B).

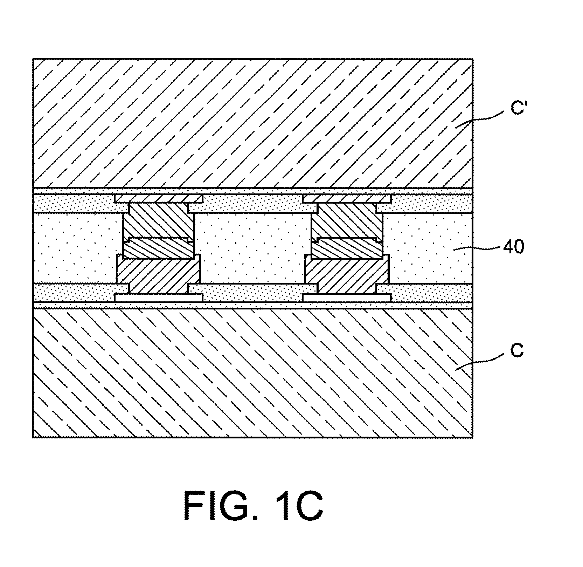

Ensuite, on forme un matériau diélectrique 40 entre les composants C, C' et autour des piliers conducteurs que l'on appelle matériau « d'underfill », qui peut être dispensé à l'aide d'une seringue et se répartir par capillarité (figure 1C). Le matériau diélectrique « d'underfill » choisi a généralement des propriétés adhésives assurant la tenue mécanique de l'assemblage.

Un tel procédé pose des problèmes en termes d'alignement des composants l'un par rapport à l'autre. Par ailleurs, ce procédé se prête mal à l'assemblage de puces ou composants ayant une grande densité d'interconnexion.

Le document US2011/0298123 A1 divulgue un procédé d'assemblage entre deux substrats, dans lequel un pilier conducteur à base de Cu, est mis en contact avec une couche de brasure.

Le document US2001/0215476 A1 présente un procédé d'assemblage entre une puce et un substrat dans lequel la puce comporte un pilier de connexion sur lequel une boule de brasure est formée pour reporter le pilier sur un plot conducteur du substrat.

Le document US 7291548 B2 présente un procédé d'assemblage entre un dispositif microélectronique formé d'une puce reportée sur un substrat, et une carte, à l'aide de billes de brasure entourées d'une couche à base d'un matériau polymère, libérateur de contrainte.

Les documents US 7 473 998 B2, US 6 578 755 B1, US 8 138 426 B2 et US 7 291 548 B2 présentent un procédé d'assemblage entre un substrat et une puce par le biais de billes de brasures formées sur la puce, les billes étant entourées d'un collier à base de matériau polymère.

Il se pose le problème d'améliorer la réalisation de structures d'assemblage de dispositifs microélectronique.

### EXPOSÉ DE L'INVENTION

La présente invention concerne tout d'abord un procédé de réalisation d'un premier dispositif microélectronique prévu pour être assemblé à un deuxième dispositif microélectronique.

Ce procédé comprend des étapes de :
a) formation, sur le premier dispositif microélectronique d'un empilement comprenant une couche conductrice recouvrant une face supérieure d'un plot conducteur et d'une couche de protection diélectrique comportant au moins une ouverture dite « première ouverture » en regard dudit plot et dévoilant ladite couche conductrice,
b) réalisation sur une zone périphérique au-dessus de la face supérieure dudit plot conducteur, d'un bloc isolant, ledit bloc isolant étant réalisé avec une section transversale formant un contour fermé et comportant une ouverture dite « deuxième ouverture » située au centre dudit bloc isolant et découvrant la première ouverture,
c) formation d'un pilier conducteur dans ladite au moins une première ouverture et deuxième ouverture par croissance à partir de ladite couche conductrice,

La hauteur du pilier conducteur et la hauteur dudit bloc isolant réalisé précédemment à l'étape b) sont prévues l'une par rapport à l'autre de sorte qu'un espace vide ou une cavité est conservé(e) entre le sommet dudit pilier conducteur et une zone d'embouchure de ladite deuxième ouverture située au niveau du sommet dudit bloc isolant.

Avec un tel procédé, on forme de manière localisée un pilier conducteur entouré d'un bloc de matériau isolant, ce pilier conducteur étant destiné à être assemblé à un élément de connexion d'un autre dispositif.

A l'aide du bloc isolant, on réalise tout d'abord une protection mécanique et électrique isolante autour du pilier conducteur.

L'espace vide ou la cavité est prévue pour accueillir un élément conducteur ou de connexion d'un autre dispositif.

Le bloc isolant forme ainsi en outre un moyen de guidage mécanique d'un élément de connexion d'un autre dispositif microélectronique que l'on peut venir assembler au dispositif microélectronique comportant le pilier conducteur.

Après l'étape c), le procédé comprend en outre une étape de gravure de ladite couche de protection diélectrique et de la couche conductrice, en se servant du bloc isolant comme d'un masquage lors de cette gravure.

On retire ainsi les zones de ladite couche de protection diélectrique et de la couche conductrice qui ne sont pas protégées par le bloc isolant.

Le fait de prévoir de réaliser ce bloc isolant à cette étape du procédé peut permettre d'éviter de réaliser un procédé de remplissage d'un matériau dit « d'underfill » après assemblage du premier dispositif avec un autre dispositif.

Selon une possibilité de mise en oeuvre, le bloc isolant peut être formé dans un matériau polymère, ou un isolant minéral tel qu'un matériau céramique.

La section transversale du bloc isolant peut prendre diverses formes par exemple celle d'un anneau ou d'un contour polygonal, en particulier carré.

La croissance du pilier conducteur peut être de type électrochimique ou de type communément appelé « electroless ».

A l'étape b), la deuxième ouverture peut dévoiler une portion de la couche diélectrique de protection.

Cela peut permettre, lorsque l'on forme le pilier conducteur de lui conférer un sommet ayant une forme qui présente une ou plusieurs courbures. Une telle forme non-plane du sommet, peut permettre de faciliter un assemblage ultérieur du pilier conducteur avec un élément de connexion.

Selon une possibilité de mise en oeuvre, la première ouverture réalisée dans la couche de protection diélectrique a un diamètre inférieur à celui de ladite deuxième ouverture située au centre du bloc isolant et dans le prolongement de ladite première ouverture.

Cela peut permettre de former un pilier conducteur de forme avantageuse avec un sommet réalisant une bosse.

Selon une autre possibilité de mise en oeuvre, la première ouverture est réalisée en périphérie d'une zone dudit empilement recouvrant une région centrale dudit plot conducteur.

Cela peut permettre de former un pilier conducteur de forme avantageuse avec un sommet dont la périphérie forme une protubérance et dont le centre a une forme concave.

De telles formes du pilier conducteur permettent de faciliter son assemblage avec un élément de connexion d'un autre dispositif microélectronique.

Selon une possibilité de mise en oeuvre, plusieurs premières ouvertures peuvent être réalisées dans la couche de protection diélectrique en regard d'un même plot conducteur et à proximité de flancs dudit bloc isolant.

Selon une possibilité de réalisation, la deuxième ouverture située au centre dudit bloc isolant comporte des parois inclinées par rapport à une normale à un plan principal du substrat.

La présente invention concerne également un procédé de réalisation d'une structure dans lequel on assemble le premier dispositif microélectronique avec un deuxième dispositif, ce procédé comprenant la réalisation d'étapes d'un procédé tel que défini plus haut, puis le report du premier dispositif microélectronique sur ledit deuxième dispositif microélectronique par insertion dans ladite ouverture d'au moins un élément de connexion du deuxième dispositif microélectronique.

Dans ce cas l'espace vide ou la cavité peut alors être occupée au moins partiellement par ledit élément de connexion du deuxième dispositif.

Après assemblage, on peut former une zone de matériau diélectrique autour dudit bloc isolant dans une région située entre le premier dispositif microélectronique et le deuxième dispositif microélectronique.

Selon un autre aspect, la présente invention concerne un dispositif microélectronique comprenant un substrat comportant au moins un plot conducteur ledit plot étant doté d'une face inférieure reposant sur le substrat et d'une face supérieure opposée à ladite face inférieure, ladite face supérieure dudit plot étant recouverte d'un empilement formé d'une couche conductrice et d'une couche de protection diélectrique comportant une ouverture dite « première ouverture » en regard dudit du plot et dévoilant ladite couche conductrice, au moins un bloc isolant étant agencé sur une zone périphérique de ladite face supérieure dudit plot, ledit bloc isolant ayant une section transversale formant un contour fermé et comportant une ouverture dite « deuxième ouverture », un pilier conducteur étant situé au centre dudit contour dans ladite deuxième ouverture.

La hauteur du pilier conducteur et la hauteur dudit bloc isolant sont prévues l'une par rapport à l'autre de sorte qu'un espace vide ou une cavité est conservé(e) entre le sommet dudit pilier conducteur et une zone d'embouchure de ladite deuxième ouverture située au niveau du sommet dudit bloc isolant.

L'invention concerne également une structure comprenant un dispositif microélectronique tel que défini plus haut, assemblé à un autre dispositif de sorte qu'un élément de connexion dudit autre dispositif est assemblé audit pilier conducteur, et entouré par ledit bloc isolant. Dans ce cas l'espace vide ou la cavité peut alors être occupée au moins partiellement par ledit élément de connexion du deuxième dispositif.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
- les figures 1A-1C illustrent un exemple de procédé d'assemblage de composants suivant l'art antérieur ;

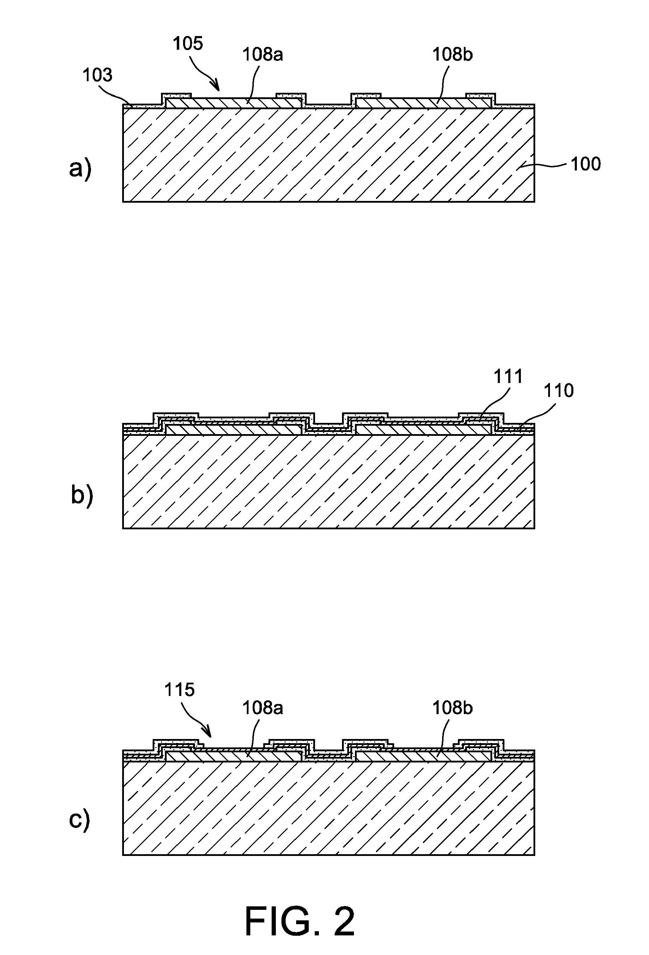

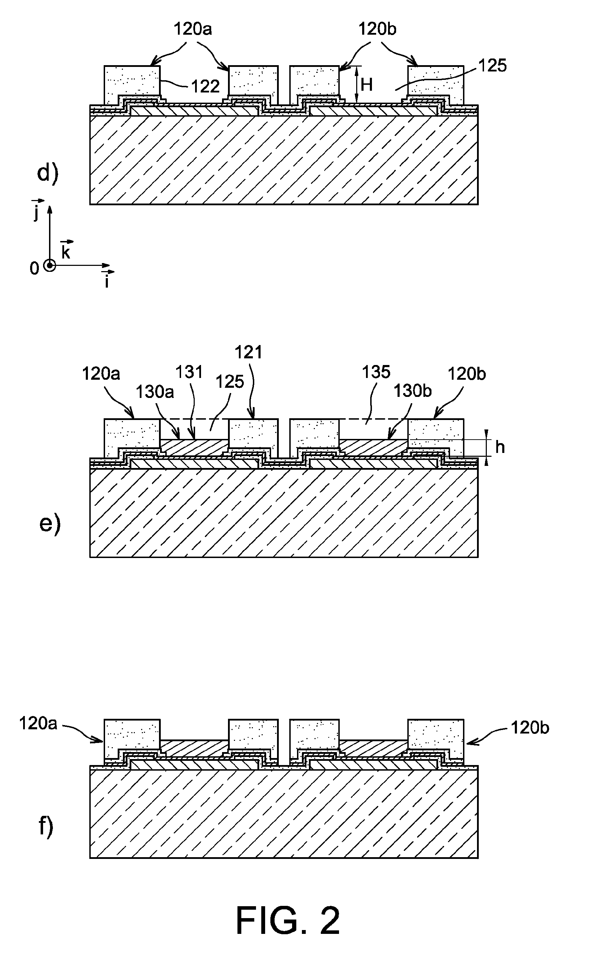

- les figures 2A-2F, illustrent un exemple de procédé suivant l'invention, de réalisation d'un dispositif microélectronique doté de piliers conducteurs sur un composant et de moyens d'isolation des piliers conducteurs permettant l'assemblage de ce dispositif microélectronique avec un autre dispositif microélectronique ;

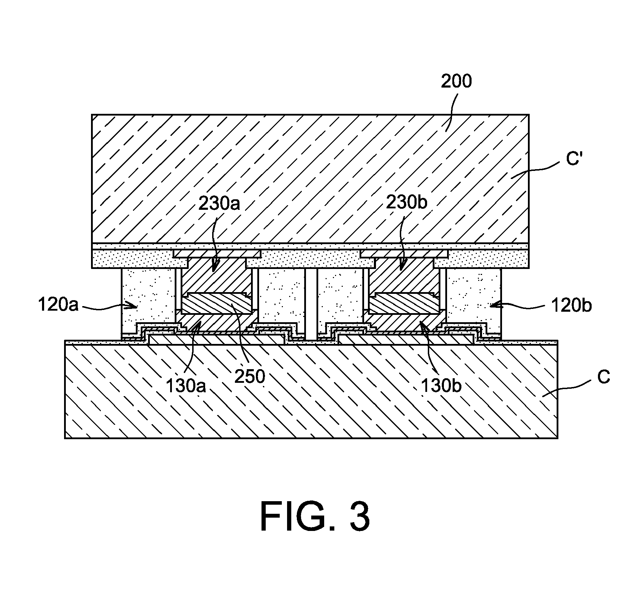

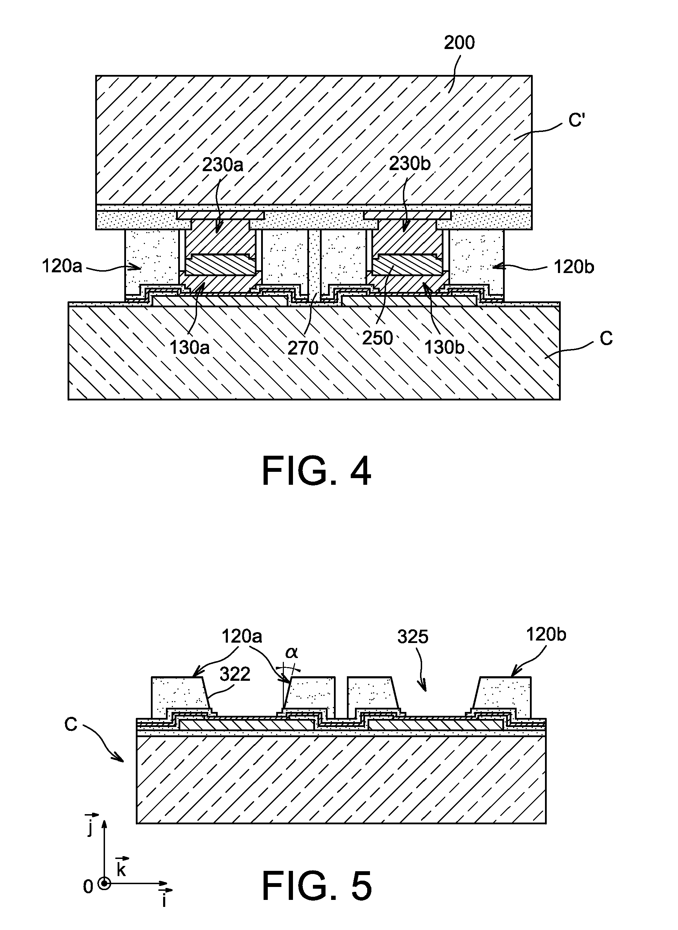

- les figures 3 et 4 illustrent un assemblage d'un dispositif microélectronique formé selon un procédé tel qu'illustré sur les figures 2A-2F avec un autre dispositif microélectronique ;
- la figure 5 illustre un exemple de forme particulière de blocs de polymère réalisés autour de piliers conducteurs d'un dispositif microélectronique, lesdits blocs de polymère permettant de réaliser une isolation des piliers conducteurs et de favoriser l'assemblage avec un autre dispositif microélectronique ;

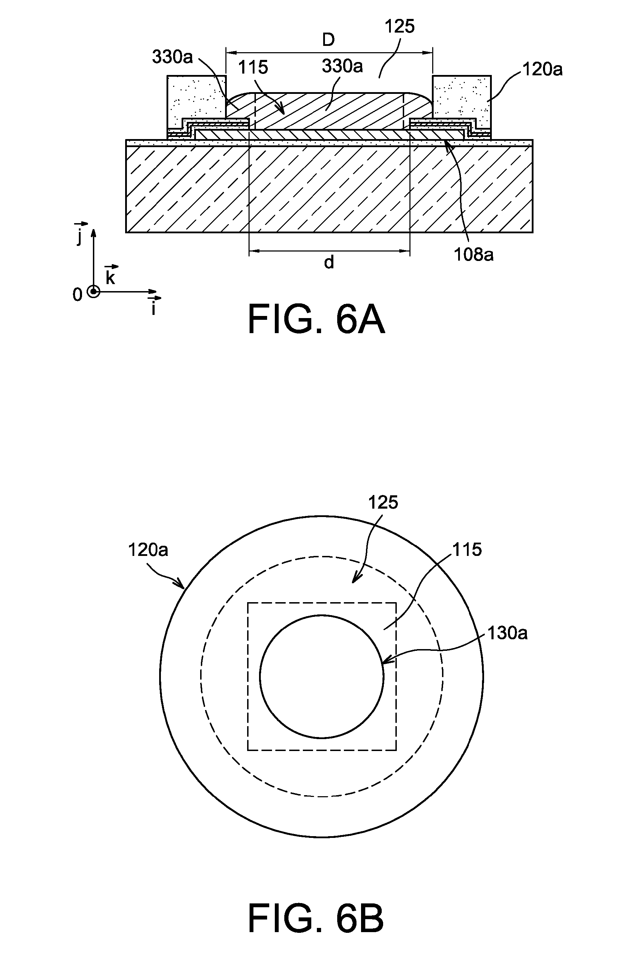

- les figures 6A-6B illustrent un dispositif microélectronique doté d'un bloc de polymère permettant de réaliser une isolation autour d'un pilier conducteur, le pilier ayant un sommet en forme de bosse et étant destiné à être assemblé à un autre élément de connexion d'un autre dispositif microélectronique ;

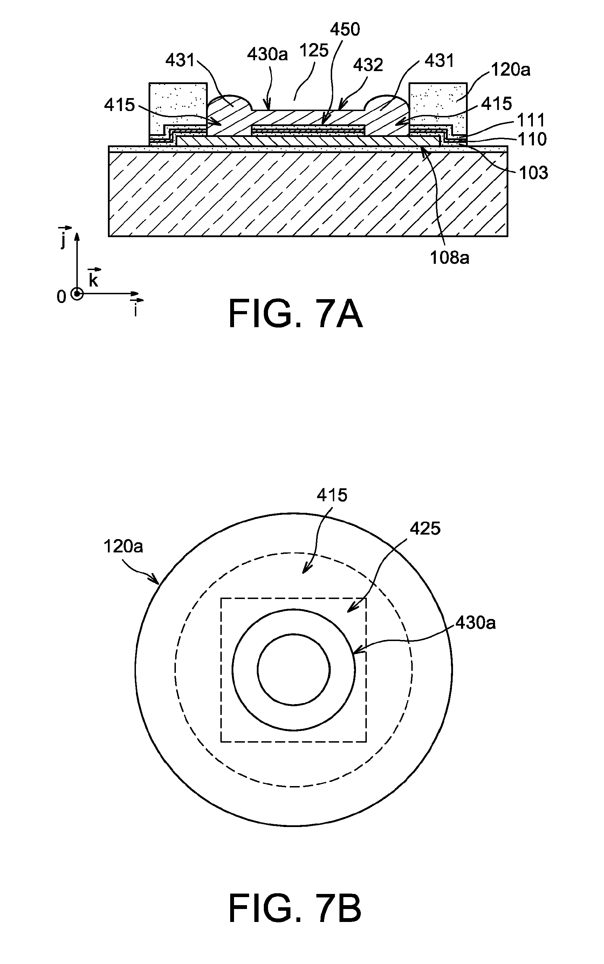

- les figures 7A-7B illustrent un dispositif microélectronique, doté d'un bloc de polymère permettant de réaliser une isolation autour d'un pilier conducteur présentant une forme de bourrelet en périphérie de son sommet, le pilier conducteur étant destiné à être assemblé à un autre élément de connexion d'un autre dispositif microélectronique ;

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

Un procédé suivant l'invention va à présent être décrit en liaison avec les figures 2A-2F.

Le matériau de départ, illustré sur la figure 2A, peut être par exemple une puce ou un composant donné C en fin de fabrication et réalisé à partir d'un substrat 100 semi-conducteur comportant, sur sa face supérieure, des plots conducteurs 108a, 108b, par exemple à base d'Al ou de Cu.

Une couche diélectrique 103 repose sur le substrat 100 ainsi que sur une zone périphérique de la face supérieure des plots conducteurs 108a, 108b.

Des ouvertures 105 sont pratiquées dans cette couche diélectrique 103 et dévoilent une zone centrale de la face supérieure des plots conducteurs 108a, 108b, les plots conducteurs 108a, 108b, étant ainsi partiellement encapsulés par la couche diélectrique 103.

Ensuite (figure 2B), on forme une couche conductrice 110 recouvrant notamment les plots conducteurs 108a, 108b, et en particulier une région centrale de la face supérieure des plots conducteurs 108a, 108b.

Cette couche conductrice 110 peut être formée d'un empilement de plusieurs couches comprenant une couche d'accroche par exemple à base de Ti ou de TiW d'épaisseur comprise par exemple entre 10 nm et 500 nm et une couche dite « de nucléation » Cu et peut avoir une épaisseur comprise par exemple entre 50 nm et 2 µm.

La couche conductrice 110 peut être réalisée par exemple à l'aide d'une technique de PVD (PVD pour « Physical Vapor Deposition »).

Puis, on réalise une couche de protection 111, recouvrant notamment la couche conductrice 110.

La couche de protection 111 peut être à base de matériau diélectrique et formée d'un empilement comprenant une couche à base de SiₓN_{y} d'épaisseur qui peut être comprise par exemple entre 5 nm et 100 nm, par exemple de l'ordre de 40 nm et une couche de SiO₂ d'épaisseur comprise par exemple entre 50 nm et 500 nm, par exemple de l'ordre de 500 nm.

Afin d'éviter de dégrader la couche conductrice 110, et en particulier la couche de nucléation, le dépôt de l'empilement diélectrique peut être réalisé par une technique par voie chimique en phase gazeuse assistée par plasma (PECVD) à basse température, par exemple inférieure à 400°C.

On forme ensuite des ouvertures 115 dans la couche de protection 111, de manière à dévoiler une région de la couche conductrice 110 située en regard des plots conducteurs 108a, 108b, en particulier au niveau de la zone centrale de la face supérieure des plots 108a, 108b. Ces ouvertures 115 peuvent être réalisées par gravure par exemple par voie chimique et/ou plasma. Dans le cas où la couche de protection est formée d'un empilement de Si₃N₄ et de SiO₂, la couche de Si₃N₄ peut servir de couche d'arrêt à la gravure de la couche de SiO₂ (figure 2C).

On forme ensuite des blocs 120a, 120b à base de matériau diélectrique autour des plots conducteurs 108a, 108b. Les blocs 120a, 120b à base de matériau diélectrique sont également disposés sur la zone périphérique des plots conducteurs 108a, 108b.

Ces blocs 120a, 120b ont une section transversale (définie sur la figure 2D dans une direction parallèle au plan [O;*̅i̅*̅;*̅k̅*̅]du repère orthogonal [O;*̅i̅*̅;*̅j̅*̅;*̅k̅*̅]) réalisant un contour fermé. Les blocs 120a, 120b peuvent par exemple avoir une forme d'anneau ou de couronne ou de contour fermé polygonal, doté(e) en son centre d'une ouverture 125 dévoilant la région centrale de la face supérieure des plots 108a, 108b conducteurs.

Les blocs 120a, 120b peuvent être formés par exemple par dépôt à la tournette (« spin coating » selon la terminologie anglo-saxonne) ou par procédé de laminage (« lamination » selon la terminologie anglo-saxonne), d'un matériau polymère par exemple à base époxy ou de silicone, ou d'un polyimide, ou de BCB (benzocyclobutène) ou de polybenzoxazole (PBO).

Ce matériau polymère peut être chargé, par exemple à l'aide de billes de SiO₂.

L'épaisseur ou la hauteur H des blocs 120a, 120b de polymère (mesurée sur la figure 2D dans une direction parallèle au vecteur *̅j̅*̅ du repère orthogonal [O;*̅i̅*̅;*̅j̅*̅;*̅k̅*̅]) peut être prévue supérieure à la hauteur de piliers conducteurs que l'on souhaite ultérieurement réaliser, et peut dépendre également de celle d'éléments de connexion d'un autre composant (non représenté sur la figure 2D) destiné à être assemblé avec ledit composant donné C, les éléments de connexion dudit autre composant étant destinés à venir s'insérer dans une ouverture 125 située au centre de l'anneau ou de la couronne et venir en appui avec des piliers conducteurs 130a, 130b dudit composant donné.

L'épaisseur des blocs 120a, 120b peut être comprise par exemple entre 3 µm et 500 µm. Le motif en forme de contour fermé réalisé dans le matériau polymère pour former les blocs 120a, 120b peut être réalisé par exemple par photolithographie avec éventuellement un masque dur (non représenté sur la figure 2D).

Au centre de la couronne ou de l'anneau, les flancs 122 des blocs 120a, 120b, appelés « internes », sont verticaux dans cet exemple, et disposés autour de la zone centrale des plots 120a, 120b.

Selon une variante de mise en oeuvre illustrée sur la figure 5, des flancs internes 322 inclinés sont prévus avec un angle α par exemple inférieur ou égal à 60°, par rapport à une normale *̅n̅*̅ au plan principal du substrat (défini sur la figure 5 comme un plan passant par le substrat et parallèle au plan [O;*̅i̅*̅;*̅k̅*̅] du repère orthogonal [O;*̅i̅*̅;*̅j̅*̅;*̅k̅*̅]) de sorte qu'une ouverture 325 au centre de l'anneau a une forme d'ouverture tronconique. Cette configuration peut permettre de faciliter ultérieurement un assemblage du composant C avec un autre composant et l'insertion d'éléments de connexion de l'autre composant dans l'ouverture 325.

Un traitement thermique, à une température par exemple comprise entre 60°C et 250°C, peut être ensuite réalisé afin de modifier les propriétés du polymère et le rendre plus dur.

Au centre du contour fermé formé par chacun des blocs 120a, 120b, les flancs internes 122 de ces blocs 120a, 120b, définissent des ouvertures 125 dans lesquelles on forme ensuite des piliers conducteurs 130a, 130b (figure 2E). Ainsi, les piliers conducteurs 130a, 130b sont réalisés sur les plots conducteurs 108a, 108b et entourées de matériau polymère. Les piliers conducteurs 130a, 130b peuvent être réalisés par dépôt de matériau métallique par électrolyse sur les zones de la couche de nucléation 110 dévoilées par les ouvertures 115 réalisées dans la couche de protection diélectrique 111.

Les piliers conducteurs 130a, 130b peuvent être formés à base de cuivre, et peuvent être recouverts d'une couche de protection contre l'oxydation, par exemple formée d'un empilement tri-couches de Ti, de Ni et d'Au (figure 2E).

Les piliers conducteurs 130a, 130b ont une hauteur h (mesurée sur la figure 2E dans une direction parallèle au vecteur *̅j̅*̅ du repère orthogonal [O;*i̅;j̅;k̅*]) comprise par exemple 1 µm et 500 µm, prévue inférieure à l'épaisseur des blocs 120a, 120b.

Ensuite, on effectue un retrait de portions dévoilées de la couche de protection diélectrique 111 puis de la couche de conduction 110, qui ne sont pas recouvertes par les blocs de polymère 120a, 120b. Les blocs 120a, 120b servent ainsi de masque de gravure.

La gravure des couches 111 et 110 peut être réalisée par exemple à l'aide de solutions d'attaque chimique ou de gravure de type plasma réactif ayant une sélectivité élevée par rapport aux blocs 120a , 120b.

La gravure de la couche de protection diélectrique 111 peut être réalisée grâce à une solution d'acide fluorhydrique dilué ou par plasma O₂/CF₄ notamment pour graver une couche diélectrique 111 à base de SiO₂.

Ensuite, la gravure de la couche conductrice 110 peut être réalisée à l'aide de solutions d'attaques chimiques de la ou des couches métalliques formant cette couche conductrice ou par gravure à l'aide d'un plasma réactif. A titre d'exemple pour une graver une couche conductrice 110 à base de cuivre, on peut utiliser une solution d'acide sulfurique ou orthophosphorique.

Le procédé peut ensuite comprendre éventuellement une étape de désoxydation des piliers 130a, 130b, en particulier lorsque ces derniers sont formés à base de cuivre.

Un assemblage du composant C donné avec un autre composant C' doté d'éléments de connexion 230a, 230b, par exemple à base de cuivre est illustré sur la figure 3.

Cet assemblage peut être réalisé par report des éléments de connexion 230a, 230b, qui sont tout d'abord insérés dans l'ouverture 125 puis assemblés aux piliers conducteurs 130a, 130b, par l'intermédiaire d'un matériau 250 de soudure à base d'un métal, de préférence fusible à basse température tel que par exemple du plomb, de l'étain, ou un alliage d'étain et d'argent.

Lors de l'insertion, les blocs 120a, 120b de polymère servent de moyens de guidage aux éléments de connexion 230a, 230b, du composant.

Lors de l'opération de soudure, le matériau polymère passe par une phase molle permettant de favoriser la mise en contact des éléments de connexion contre les piliers conducteurs 130a, 130b. Ensuite, le polymère passe par une phase de réticulation dans laquelle il durcit.

L'assemblage peut être réalisé à l'aide d'un équipement de type « prise-dépose » (« pick and place » selon la terminologie anglo-saxonne).

Selon une possibilité de mise en oeuvre du report, un liquide visqueux tel que par exemple un flux de soudure peut être déposé sur le matériau de soudure, pour faciliter la formation d'une zone métallique joignant les piliers conducteurs 130a, 130b, et les éléments de connexion 230a, 230b.

Un traitement de désoxydation des éléments de connexion 230a, 230b peut être ensuite éventuellement réalisé.

A l'issue de l'assemblage, les parois internes 122 des blocs 120a, 120b de matériau polymère, ainsi que les supports respectifs du composant donné C et dudit autre composant C' peuvent former une enceinte fermée autour de l'assemblage entre les éléments de connexion 230a, 230b et les piliers conducteurs 130a, 130b. Cela permet de protéger et d'isoler électriquement les piliers conducteurs 130a, 130b et les éléments de connexion 230a, 230b.

Ensuite, dans le cas (figure 3) où les dimensions des blocs 120a, 120b sont telles qu'un espace 260 vide existe entre eux on peut combler cet espace vide 260 par exemple à l'aide d'un matériau diélectrique 270 qui peut être par exemple un polymère (figure 4).

Le procédé qui vient d'être décrit n'est pas nécessairement limité à une réalisation à partir d'un composant C en fin de fabrication, mais peut être aussi appliqué par exemple à un assemblage sur une carte, ou un substrat, ou un interposeur.

Sur les figures 6A-6B, une variante de réalisation d'un pilier conducteur 330a est illustrée (respectivement selon une vue de dessus, et selon une vue en coupe transversale).

Le bloc 120a isolant autour du pilier conducteur 330a est réalisé de sorte que l'ouverture 125 prévue en son centre dévoile une portion de la couche diélectrique de protection.

Pour cette variante, l'ouverture 125 située au centre de l'anneau formé par le bloc isolant 120a est prévue avec un diamètre D supérieur au diamètre de l'ouverture 115 pratiquée dans la couche de protection diélectrique 111 (ces diamètres étant mesurés dans une direction parallèle au plan [O;*̅i̅*̅;*̅k̅*̅] du repère orthogonal ([O*;i̅;j̅;k̅*]).

Cela permet de conférer une forme bombée ou de bosse au sommet du pilier conducteur 330a. Une telle forme peut être avantageuse lors de la réalisation de la soudure et de l'assemblage avec un élément de connexion d'un autre composant.

Sur les figures 7A-7B, une variante de réalisation d'un pilier conducteur 430a est illustrée (respectivement selon une vue de dessus, et selon une vue en coupe transversale).

Pour cette variante, une ouverture 415, sous forme de tranchée réalisant un contour fermé, est pratiquée dans l'empilement formé par la couche de protection diélectrique 111, la couche conductrice 110 et la couche diélectrique 103,

L'ouverture 415, est placée dans une région de la face supérieure du plot conducteur 108a, située autour d'une zone 450 de l'empilement de couches 111, 110, et 103 conservées sur le plot 108a.

De par l'agencement de cette ouverture 415, qui dévoile une portion de la couche diélectrique de protection 111, la croissance électrolytique de matériau métallique conduit à la formation d'un pilier conducteur 330a comportant un bourrelet ou une protubérance 431 en périphérie de son sommet, le pilier conducteur 430a comportant ainsi une zone convexe 432 dans une région central de son sommet. Une telle forme du pilier conducteur 430a peut permettre de favoriser l'assemblage avec un élément de connexion d'un autre composant que l'on vient insérer dans l'ouverture 125 au centre de l'anneau.

## Revendications

1. Procédé de réalisation d'un premier dispositif microélectronique destiné à être assemblé à un deuxième dispositif microélectronique, le procédé comprenant des étapes de :
a) formation, sur le premier dispositif microélectronique comportant au moins un plot conducteur (108a, 108b) ledit plot ayant une face inférieure reposant sur un substrat (100) et une face supérieure opposée à ladite face inférieure, d'un empilement comprenant une couche conductrice (110) recouvrant ledit plot et d'une couche de protection diélectrique (111) comportant au moins une ouverture (115) dite « première ouverture » en regard dudit plot et dévoilant ladite couche conductrice (110),
b) réalisation sur une zone périphérique au-dessus de la face supérieure dudit plot conducteur, d'un bloc isolant (120a, 120b), ledit bloc isolant étant réalisé avec une section transversale formant un contour fermé et comportant une ouverture (125) dite « deuxième ouverture » située à l'intérieur dudit bloc isolant et dévoilant au moins partiellement la première ouverture (115),
c) formation dans ladite au moins une première ouverture (115) et deuxième ouverture (125) d'un pilier conducteur (130a, 130b) par croissance à partir de ladite couche conductrice (110), la hauteur du pilier conducteur (130a, 130b) et la hauteur dudit bloc isolant (120a, 120b) étant prévues l'une par rapport à l'autre de sorte qu'un espace vide (135) ou une cavité (135) est conservé(e) entre le sommet (131) dudit pilier conducteur et une zone d'embouchure de ladite deuxième ouverture située au niveau du sommet (121) dudit bloc isolant (120a, 120b),
le procédé comprenant en outre après l'étape c), une étape de gravure de ladite couche de protection diélectrique (111) et de la couche conductrice (110) en se servant du bloc isolant (120a, 120b) comme d'un masquage de protection à la gravure.

2. Procédé selon la revendication 1, l'espace vide (135) étant prévu de sorte à permettre une insertion dans ladite ouverture (125) d'au moins un élément de connexion (230a, 230b) d'un deuxième dispositif microélectronique destiné à être assemblé avec ledit premier dispositif microélectronique.

3. Procédé selon l'une des revendications 1 ou 2, dans lequel la première ouverture (115) réalisée dans la couche de protection diélectrique (111) a un diamètre inférieur à celui de ladite deuxième ouverture (125) située à l'intérieur du bloc isolant (120a, 120b) et dévoilant ladite première ouverture.

4. Procédé selon l'une des revendications 1 ou 2, dans lequel la première ouverture (415) est réalisée en périphérie d'une zone (450) dudit empilement recouvrant une région centrale dudit plot conducteur (108a, 108b).

5. Procédé selon l'une des revendications 1 à 4, dans lequel ladite deuxième ouverture (125) située au centre dudit bloc isolant (120a, 120b) comporte des parois inclinées (322) par rapport à une normale à un plan principal du substrat (100).

6. Procédé de réalisation d'une structure formée d'un premier dispositif microélectronique sur lequel est assemblé un deuxième dispositif (200), comprenant la réalisation d'un procédé selon l'une des revendications 1 à 5, puis le report du deuxième dispositif microélectronique (200) sur ledit premier dispositif microélectronique (100) par insertion dans ladite deuxième ouverture (125) d'au moins un élément de connexion (230a, 230b) du deuxième dispositif microélectronique et assemblage dudit élément de connexion audit pilier conducteur dudit premier dispositif microélectronique.

7. Procédé selon la revendication 6, comprenant en outre, après assemblage, la formation de matériau diélectrique (220) autour dudit bloc isolant (120a, 120b) dans une zone située entre le premier dispositif microélectronique et le deuxième dispositif microélectronique.

8. Procédé selon l'une des revendications 1 à 7, dans lequel plusieurs premières ouvertures (415a, 415b) sont réalisées dans la couche de protection diélectrique (111) en regard d'un même plot conducteur et à proximité de flancs dudit bloc isolant (120a).

9. Dispositif microélectronique de connexion comprenant un substrat comportant au moins un plot (108a, 108b) conducteur ledit plot étant doté d'une face inférieure reposant sur le substrat et d'une face supérieure opposée à ladite face inférieure, ladite face supérieure dudit plot étant recouverte d'un empilement comportant une couche conductrice (110) et une couche de protection diélectrique (111) comportant une ouverture (115) dite première ouverture en regard dudit du plot et dévoilant ladite couche conductrice (110), au moins un bloc (120a, 120b) isolant étant agencé sur une zone périphérique de ladite face supérieure dudit plot, ledit bloc isolant (120a, 120b) ayant une section transversale formant un contour fermé et comportant une ouverture (125) dite deuxième ouverture, un pilier conducteur (130a, 130b) étant situé à l'intérieur dudit contour dans ladite deuxième ouverture, la hauteur du pilier conducteur (130a, 130b) et la hauteur dudit bloc isolant (120a, 120b) étant prévues l'une par rapport à l'autre de sorte qu'un espace vide (135) ou une cavité (135) est prévu(e) entre le sommet (131) dudit pilier conducteur et une zone d'embouchure de ladite deuxième ouverture située au niveau du sommet (121) dudit bloc isolant (120a, 120b).

10. Structure de connexion comprenant un dispositif microélectronique selon la revendication 9, sur lequel est assemblé un autre dispositif (200) de sorte qu'un élément de connexion (230a, 230b) dudit autre dispositif est assemblé audit pilier conducteur, et entouré par ledit bloc isolant (120a, 120b).
